# EUROPEAN PATENT APPLICATION

(11) **EP 4 394 265 A1**
(43) Date of publication of application: **03.07.2024**
(21) Application number: 23220351.3
(22) Date of filing: 27.12.2023
(51) Int. Cl.: F24F 1/0057, F24F 1/0063, F24F 11/52

(54) **INDOOR UNIT OF AIR CONDITIONER**

(30) Priority: 26.12.2022 KR 20220184396
(71) Applicant: LG Electronics Inc., Yeongdeungpo-gu Seoul 07336 (KR)
(72) Inventor: Jung, Yuheon, 08592 Seoul (KR); Lee, Eunsun, 08592 Seoul (KR); Kim, Kyungtae, 08592 Seoul (KR)
(74) Representative: Ter Meer Steinmeister & Partner

(57) **Abstract**

An indoor unit of an air conditioner according to the present disclosure includes: a cabinet having an inlet through which outside air is introduced and an outlet through which air is discharged; a heat exchanger disposed in the cabinet; a blower fan disposed in the cabinet; a display panel comprising a display unit, the display panel being coupled to one surface of the cabinet; and an air gap that defines an empty space between the display panel and the cabinet, wherein outside air is introduced through the air gap, is heat-exchanged with the display unit, and is discharged to an outside through the air gap.

## Description

### BACKGROUND

### Field

The present disclosure relates to an indoor unit of an air conditioner, and more particularly, to an indoor unit of an air conditioner that can effectively cool heat generated in a display of the indoor unit, and to an air conditioner including the same.

### Description of the Related Art

In general, an air conditioner is an apparatus for cooling and heating an indoor space by using a refrigerant refrigeration cycle consisting of a compressor, a four-way valve, an outdoor heat exchanger (condenser or evaporator), an expansion mechanism, and an indoor heat exchanger (evaporator or condenser) to create a more comfortable indoor environment for users. Air conditioners may be classified into a separated-type air conditioner and an integrated-type air conditioner.

The separate-type air conditioner and the integrated-type air conditioner are functionally the same. In the case of the separate-type air conditioner, an indoor unit (in which a heat dissipation/cooling device, an indoor fan, and an indoor fan motor are installed) and an outdoor unit (in which a heat dissipation/cooling device, a compressor, an outdoor fan, and an outdoor fan motor are installed) are separated from each other and are connected by a refrigerant pipe. In the case of the integrated-type air conditioner, the functions of cooling and heat dissipation are integrated.

The separate-type air conditioner is usually installed by placing an indoor unit upright in an indoor space, hanging the indoor unit on a wall, or embedding the indoor unit in a ceiling, while the integrated-type air conditioner is installed by drilling a hole in a wall of a house, installing a device on a window, or being placed outdoors and connected to an indoor space by a duct.

In the case of an indoor unit of an air conditioner of the related art (Patent Document 1), which is hereby incorporated by reference, a chassis does not include a display, and accordingly, a separate heat dissipation passage or a cooling element is not provided.

In the case of an indoor unit of an air conditioner of the related art (Patent Document 2), which is hereby incorporated by reference, a frame or a display configured to display information regarding the indoor unit is disposed at a front surface of a cabinet (10) in which a heat exchanger and a blower fan are accommodated and provided with an inlet (15) through which outside air is drawn in and an outlet (40) through which air is discharged.

In the case of the Patent Document 2, a large-sized display is employed to meet the user's needs and improve visibility. However, such a display is disposed at a display panel (30), overheating of the display may be caused, leading to damage to the indoor unit or overheating of the indoor unit.

In addition, the Patent Document 2 does not provide a structure that can effectively dissipate heat generated in a control unit configured to control the display and the indoor unit. The heat generated in the control unit may cause overheating of the indoor unit or damage to the indoor unit.

### Related Art

### Patent Document

Patent Document 1- Korean Laid-Open Patent Publication No. 20160085355
Patent Document 2- Korean Laid-Open Patent Publication No. 20060011656

### SUMMARY

It is an object of the present disclosure to provide an indoor unit of an air conditioner that can effectively dissipate heat generated in a display and/or in a control unit, and to an air conditioner including the same.

It is another object of the present disclosure to provide an indoor unit of an air conditioner with increased rigidity of a display, and to an air conditioner including the same.

It is yet another object of the present disclosure to provide an indoor unit of an air conditioner that can effectively cool heat, generated in a display and/or a control unit, by natural convection, without rotating a blower fan, and to an air conditioner including the same.

It is yet another object of the present disclosure to provide an indoor unit of an air conditioner that enables forced convection and rapid cooling by rotating a blower fan when heat generated in a display and/or a control unit exceeds the amount of cooling by natural convection, and to an air conditioner including the same.

It is yet another object of the present disclosure to provide an indoor unit of an air conditioner that can allow outside air to be concentrated into a control unit where heat is more generated compared to a display, and to an air conditioner including the same.

It is yet another object of the present disclosure to provide an indoor unit of an air conditioner with improved visibility of an image displayed on a display, and to an air conditioner including the same.

It is yet another object of the present disclosure to provide an indoor unit of an air conditioner that can allow an image displayed on a display to be easily changed, and to an air conditioner including the same.

At least one of these objects is solved by the features of the independent claim. The objects of the present disclosure are not limited to the objects described above, and other objects not stated herein will be clearly understood by those skilled in the art from the following description.

An indoor unit of an air conditioner according to the present disclosure may be characterized in that an air gap is positioned between a display panel and a cabinet.

An indoor unit of the air conditioner according to the present disclosure may be characterized in that one surface of a display unit and one surface of a control unit are exposed at the air gap.

An indoor unit of the air conditioner according to the present disclosure may be characterized in that a blower fan is rotated in response to a temperature of the control unit being higher than a critical temperature.

According to an aspect of the present invention, an indoor unit of an air conditioner includes: a cabinet having an inlet through which outside air is introduced and an outlet through which air is discharged; a heat exchanger disposed in the cabinet; a blower fan disposed in the cabinet; a display panel comprising a display unit, the display panel being coupled to one surface of the cabinet; and an air gap that defines an empty space between the display panel and the cabinet.

According to an aspect of the present invention, an indoor unit of an air conditioner includes: a cabinet having an inlet through which outside air is introduced and an outlet through which air is discharged; a heat exchanger disposed in the cabinet; a blower fan disposed in the cabinet; a display panel comprising a display unit, the display panel being coupled to one surface of the cabinet; and an air gap that defines an empty space between the display panel and the cabinet, wherein outside air is introduced through the air gap, is heat-exchanged with the display unit, and is discharged to an outside through the air gap.

According to an aspect of the present invention, an indoor unit of an air conditioner includes: a cabinet having an inlet through which air is introduced and an outlet through which air is discharged; a heat exchanger disposed in the cabinet; a blower fan disposed in the cabinet; a display panel comprising a display unit, the display panel being coupled to one surface of the cabinet; and an air gap between the display panel and the cabinet for allowing air to flow along the display panel for heat-exchange with the display panel and/or for cooling the display panel.

The indoor unit according to any one of these aspects may include one or more of the following features:

The indoor unit may be a wall-type indoor unit, i.e. to be mounted on a wall or vertical surface (i.e. the heat exchanger and/or the display panel and/or a front surface/panel of the cabinet being in a vertical orientation). The front surface and/or front panel of the cabinet may be parallel to a surface on which the indoor unit is mounted.

The blower fan may be configured to draw in air through the inlet through/via the heat exchanger. That is, air drawn in through the inlet by the blower fan may pass through the heat exchanger.

The display panel may be mounted at/on an outer surface of the cabinet, e.g. a front surface and/or front panel of the cabinet.

The air gap may be defined as an empty space between the display panel and the cabinet. The air gap may be disposed in front of or adjacent to the inlet and/or between the inlet and the display panel. The air gap may communicate with and/or be open to an outside of the indoor unit at a lower and/or upper side of the indoor unit, e.g. to allow air to flow through the air gap in vertical direction (i.e. upwards), such as due to natural convection.

The air gap may include a first air gap positioned at a lower portion of the indoor unit, e.g. at a lower portion or a lower side of the display panel, and/or a second air gap positioned at an upper portion of the indoor unit, e.g. at an upper portion or an upper side of the display panel. The air gap may include a third air gap in communication with the first air gap and the second air gap and/or fluidly connecting the first air gap and the second air gap to each other. The first air gap and the second air gap may be arranged in a vertical direction, e.g. one above the other.

The air gap may include a first air gap positioned below the display unit and/or a second air gap positioned above the display unit. The air gap may include a third air gap in communication with the first air gap and the second air gap and/or fluidly connecting the first air gap and the second air gap to each other.

The first air gap may be open and/or in communication with an outside at a lower portion of the indoor unit, e.g. at a lower portion or a lower side of the display panel. The first air gap may be formed between a lower portion/side of the display panel and a lower portion/side of the cabinet. The second air gap may be open and/or in communication with an outside at an upper portion of the indoor unit, e.g. at an upper portion or an upper side of the display panel. The second air gap may be formed between an upper portion/side of the display panel and an upper portion/side of the cabinet. The outside air may be introduced into the first air gap, may be heat-exchanged with the display unit in the third air gap, and may be discharged to the outside through the second air gap. This may be due to natural convection.

The third air gap may be positioned to overlap the display unit in a horizontal direction.

The inlet may be positioned at a surface of the cabinet that faces the display panel. The inlet and/or the display panel may be positioned at a front surface and/or front panel of the cabinet.

The inlet may be in communication with the air gap.

The inlet may be positioned to overlap the display unit in a rotation axis of the blower fan. That is, a virtual extension line of a rotation axis of the blower fan may pass through the inlet and through the display unit. The virtual extension line may also pass through the (third) air gap. A rotation axis of the blower fan may be perpendicular to the display panel and/or to a front surface and/or front panel of the cabinet.

The display panel may include a panel inlet. The panel inlet may be a hole formed through a lower surface of the display panel. The panel inlet may be in communication with the (first) air gap.

The display panel may include a rear frame facing the cabinet and a front frame opposite to the rear frame. The display unit may be disposed between the front frame and the rear frame. The rear frame may form at least a portion of a surface of the (third) air gap.

The display unit may have one surface exposed at or in the air gap. The display panel may be disposed in the (third) air gap.

The display panel may further include a control unit configured to control the display unit.

The control unit may be disposed on one surface of the display unit and/or may be exposed at or in the air gap. The control unit may be disposed in the (third) air gap.

The indoor unit and/or the display panel may further include an air guide configured to guide air flowing through the air gap to the control unit. The air guide may be mounted on the rear frame.

The air guide may include a first air guide and a second air guide disposed to face the first air guide. The control unit may be positioned between the first air guide and the second air guide.

The air guide may include a lower section that is positioned at a lower height than the control unit and a central section that has at least a portion positioned at a same height as the control unit. A distance between the first air guide and the second air guide in the lower section may be greater than a distance between the first air guide and the second air guide in the central section.

The distance between the first air guide and the second air guide in the lower section may decrease toward the central section.

The air guide may further include an upper section positioned at a higher height than the control unit. A distance between the first air guide and the second air guide in the upper section may be greater than the distance between the first air guide and the second air guide in the central section.

The distance between the first air guide and the second air guide in the upper section may decrease toward the central section.

The indoor unit may further include at least one of a chip control sensor to measure a temperature of the control unit, and a controller to control the blower fan. The controller may be configured to control the blower fan to rotate based on the temperature of the control unit being higher than a critical temperature.

The controller may be configured to, based on the temperature of the control unit being higher than the critical temperature, rotate the blower fan at a speed lower than a speed in a normal operation.

According to another aspect, an indoor unit of an air conditioner includes: a cabinet having an inlet through which outside air is introduced and an outlet through which air is discharged; a heat exchanger disposed in the cabinet; a blower fan disposed in the cabinet; a display panel comprising a display unit and a control unit configured to control the display unit, the display panel being coupled to one surface of the cabinet; and an air gap formed between the display panel and the cabinet, wherein outside air is introduced through the air gap, is heat-exchanged with the display unit and the control unit, and is discharged to an outside through the air gap.

The present disclosure may further include an air guide to guide air flowing through the air gap to the control unit.

One surface of the display unit and one surface of the control unit may be exposed at the air gap.

According to a further aspect, an air conditioner may be provided including an indoor unit according to any one of the herein described aspects and embodiments.

### BRIEF DESCRIPTION OF THE DRAWINGS

FIG. 1 is a perspective view showing an indoor unit of an air conditioner according to an embodiment of the present disclosure.
FIG. 2 is a perspective view showing an open state of a display panel of the indoor unit in FIG. 1.
FIG. 3 is an exploded perspective view of the indoor unit in FIG. 1.
FIG. 4A is a cross-sectional view taken along line 4-4' of FIG. 1.
FIG. 4B is an enlarged cross-sectional view of a portion of FIG. 4A.
FIG. 5 is a bottom view of the indoor unit in FIG. 1.
FIG. 6 illustrates a display panel in FIG. 1, when viewed from the rear.
FIG. 7A illustrates an air flow by natural convection while the display panel is closed.
FIG. 7B illustrates an air flow when a blower fan is operated while the display panel is closed.
FIG. 7C illustrates an air flow when a blower fan is operated while the display panel is open.
FIG. 7D illustrates an air flow when a blower fan is not operated while the display panel is open.
FIG. 8 illustrates an air flow in the vicinity of a control unit.
FIG. 9A illustrates a display panel according to another embodiment of the present disclosure, when viewed from the rear.
FIG. 10 is a control block diagram according to an embodiment of the present disclosure.

### DETAILED DESCRIPTION

Advantages and features of the present disclosure and methods for achieving those of the present disclosure will become apparent upon referring to embodiments described later in detail with reference to the attached drawings. However, embodiments are not limited to the embodiments disclosed hereinafter and may be embodied in different ways. The embodiments are provided for perfection of disclosure and for informing persons skilled in this field of art of the scope of the present disclosure. The same reference numerals may refer to the same elements throughout the specification.

Spatially-relative terms such as "below", "beneath", "lower", "above", or "upper" may be used herein to describe one element's relationship to another element as illustrated in the Figures. It will be understood that spatially-relative terms are intended to encompass different orientations of the device in addition to the orientation depicted in the Figures. For example, if the device in one of the figures is turned over, elements described as "below" or "beneath" other elements would then be oriented "above" the other elements. The exemplary terms "below" or "beneath" can, therefore, encompass both an orientation of above and below. Since the device may be oriented in another direction, the spatially-relative terms may be interpreted in accordance with the orientation of the device.

The terminology used in the present disclosure is for the purpose of describing particular embodiments only and is not intended to limit the disclosure. As used in the disclosure and the appended claims, the singular forms "a", "an" and "the" are intended to include the plural forms as well, unless context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

In the drawings, the thickness or size of each layer is exaggerated, omitted, or schematically illustrated for convenience of description and clarity. Also, the size or area of each constituent element does not entirely reflect the actual size thereof.

Hereinafter, exemplary embodiments of the present disclosure will be described with reference to the accompanying drawings.

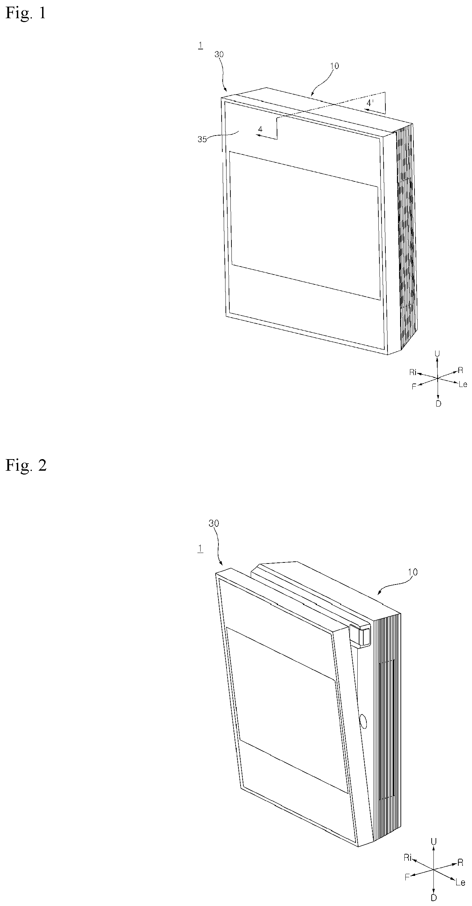

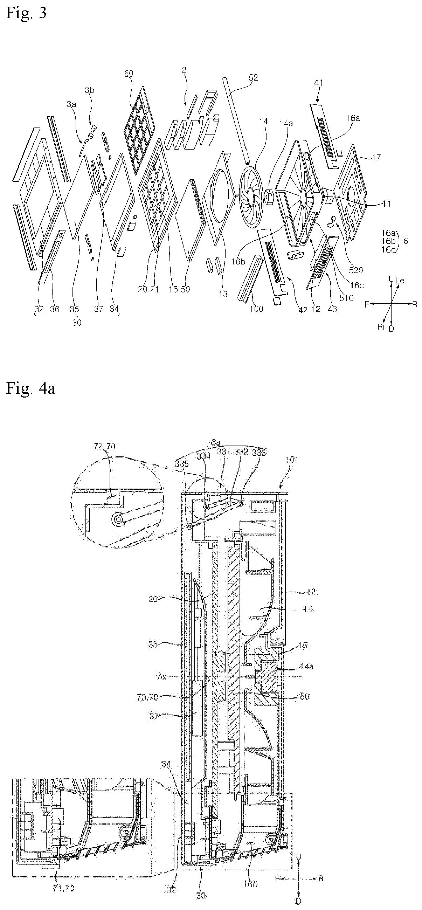

FIG. 1 is a perspective view showing an indoor unit of an air conditioner according to an embodiment of the present disclosure, FIG. 2 is a perspective view showing an open state of a display panel of the indoor unit in FIG. 1, and FIG. 3 is an exploded perspective view of the indoor unit in FIG. 1.

Referring to FIGS. 1 to 3, an indoor unit of an air conditioner according to an embodiment of the present disclosure includes a cabinet 10 and a display panel 30 coupled to a front surface of the cabinet 10. The cabinet 10 includes therein a base 12 having a space in which a blower fan 14, an orifice 13, and a heat exchanger 50 are accommodated and a front panel 20 configured to cover the base 12.

The display panel 30 is installed to the front panel 20 while being spaced apart from the front panel 20 by a predetermined distance.

The front panel 20 is provided at its center with an inlet 15 and is fixed or secured to the cabinet 10, and the cabinet 10 is provided with at least one outlet 16.

The outlet 16 may include a first outlet 16a, 16b and a second outlet 16c. The first outlet 16a, 16b may include a left outlet 16a that is disposed at a left side of the cabinet 10 and a right outlet 16b that is disposed at a right side of the cabinet 10. The second outlet 16c may be disposed at a bottom side of the cabinet 10.

Specifically, the first outlet 16a, 16b and the second outlet 16c may be formed in the base 12.

Here, a front-and-rear direction (FR) refers to a direction parallel to a rotation axis Ax of the blower fan 14. With respect to the blower fan 14, a direction to the display panel 30 is defined as a forward or front direction F, and a direction to the base 12 is defined as a rearward or rear direction R.

In addition, an up-and-down direction (UD) refers to a direction perpendicular to the rotation axis of the blower fan 14. With respect to the rotation axis Ax of the blower fan 14, a direction to the second outlet 16c is defined as a downward or down direction D, and a direction opposite to the downward direction is defined as an upward or up direction U.

Also, a left-and-right direction (LeRi) refers to a direction perpendicular to the up-and-down direction and the left-and-right direction.

The display panel 30 may be installed at the front of the front panel 20 while being spaced apart from the front panel 20 by a predetermined distance, thereby forming a gap. Air flows to the inlet 15 through the gap formed between the front panel 20 and the display panel 30.

The base 12 may be provided with the blower fan 14 through which indoor air is drawn in/discharged, the orifice 13 disposed at the front of the blower fan 14 to guide air drawn in through the inlet 15 to the blower fan 14, and the heat exchanger 50 installed at the front of the orifice 13.

Here, the blower fan 14 is installed between the base 12 and the orifice 13 to guide all of the air drawn in through the inlet 15 to the outlet 16.

The blower fan 14 is a centrifugal fan configured to discharge air introduced from the orifice 13 in a circumferential direction. A fan motor 14a configured to rotate the blower fan 14 is connected to the blower fan 14.

The left outlet 16a and the right outlet 16b, which are configured to guide air discharged from the blower fan 14 to an outside of the cabinet 10, are formed on both sides of the blower fan 14, namely, both sides of the base 12.

In addition, the second outlet 16c configured to guide air discharged from the blower fan 14 to the outside of the cabinet 10 may be provided on a bottom side of the base 12. The second outlet 16c may be provided with a control vane 510 configured to open and close the second outlet 16c, and a vane motor 520 configured to rotate the control vane 510.

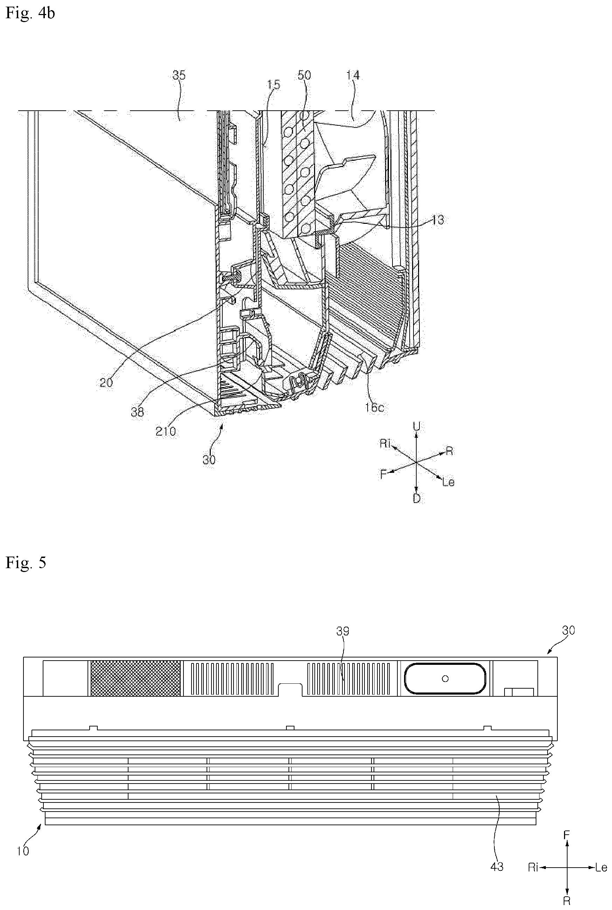

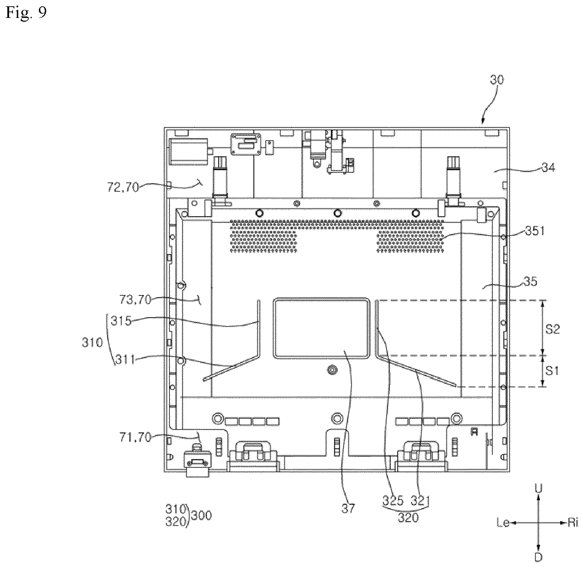

A side cover 41, 42 and a lower cover 43 to cover at least the outlet 16 may be coupled to both side surfaces and a lower surface of the base 12. The side cover 41, 42 may be provided with a discharge guide 412 configured to guide air discharged from the outlet 16. The side cover 41, 42 may include a left cover 41 and a right cover 42. The side cover 41, 42 and the lower cover 43 may be collectively referred to as a cover. This will be described in detail later with reference to FIG. 4 and FIG. 9.

The base 12 is fixed to a wall of an indoor space by a bracket 17 installed on a rear surface of the base 12.

Meanwhile, an electrical unit 2 constituting a controller 560 of the air conditioner is installed on an upper portion of the orifice 13.

The heat exchanger 50 is installed at the front of the orifice 13 to cool/heat introduced indoor air heat-exchanged with indoor air, and a drain pan 100 is disposed under the heat exchanger 50 to store (or collect) and discharge condensate generated in the heat exchanger 50.

Here, the heat exchanger 50 is fixed to the front panel 20 or the orifice 13, and is provided at its one side with a connecting pipe 52 so as to be connected to a refrigerant pipe (not shown) installed from the outside.

The front panel 20 is disposed at the front of the heat exchanger 50 to be coupled to the base 12.

The cabinet 10 is provided at its corner with a pipe cover 11, and the pipe cover 11 is installed at a corner of the base 12 to thereby define a portion of the outer appearance of the indoor unit.

Here, the pipe cover 11 is provided at a plurality of corners among four corners of the cabinet 10. In this embodiment, two pipe covers 11 are respectively installed at two lower corners of the cabinet 10, and an external refrigerant pipe passes through the pipe cover 11 to be guided inside the cabinet 10.

The front panel 20 is provided with the inlet 15 at its central portion and a front grille 21 by which the inlet 15 is divided into a plurality of regions.

The inlet 15 is provided with a filter 60 to filter indoor air flowing to the orifice 13.

Meanwhile, the filter 60 according to the present disclosure is detachably attached to the front panel 20, and in this embodiment, the filter 60 is supported by the front grille 21 of the front panel 20.

Here, the filter 60 and the front grille 21 that supports the filter 60 may be formed by gently protruding forward by a predetermined thickness with respect to the front panel 20. The filter 60 supported by being seated on the front grille 21 is prevented from contact with the heat exchanger 50.

Meanwhile, the display panel 30 may be hinged to the front panel 20 by a link assembly 3. The link assembly 3 may include a link 3a and a link motor 3b. The display panel 30 may maintain an open state, as shown in FIG. 2, by the operation of the link assembly 3. An opening operation may be performed in a state where at least a portion of a lower end of the display panel 30 is fixed to the front panel 20. In the open state, outside air may be introduced into the inlet 15 between an inlet space formed between the display panel 30 and the front panel 20. As the display panel 30 maintains the open state, visibility of the display panel 30 can be increased.

In order for the stable operation of the link assembly 3, an auxiliary link 3c may be further provided. In this embodiment, an auxiliary link 3c that is hinged to the display panel 30 and the front panel 20 may be provided at each of left and right sides below the link 3a.

The display panel 30 may be provided with a display unit 35 configured to display an operation state of the indoor unit, etc. The display panel 30 includes a rear frame 34 and a front frame 32, and the display unit 35 is disposed between the front frame 32 and the rear frame 34.

The front frame 32 may have an opening through which the display unit 35 is exposed. A side frame 36 may be installed at a portion where the front frame 32 and the rear frame 34 are coupled.

Hereinafter, a structure for cooling the display unit 35 will be described.

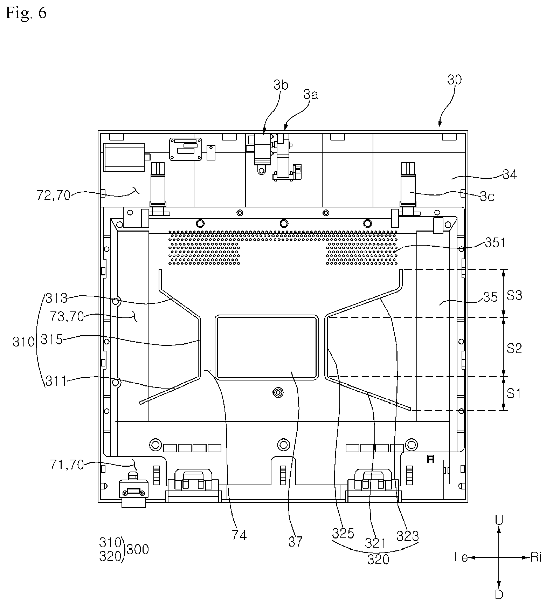

FIG. 4A is a cross-sectional view taken along line 4-4' of FIG. 1, FIG. 4B is an enlarged cross-sectional view of a portion of FIG. 4A, FIG. 5 is a bottom view of the indoor unit in FIG. 1, and FIG. 6 illustrates a display panel in FIG. 1, when viewed from the rear.

Referring to FIGS. 4A to 6, the display panel 30 according to an embodiment of the present disclosure includes a panel inlet 39 and a vent hole 351, and an air gap 70 is formed between the display panel 30 and the cabinet 10.

The display panel 30 includes a rear frame 34 and a front frame 32, and a display unit 35 is accommodated between the front frame 32 and the rear frame 34. A front surface of the display unit 35 is exposed at the front through the front frame 32. The display unit 35 may have a smaller area than the front frame 32 and the rear frame 34.

The display unit 35 may be provided with a control unit 37. The control unit 37 may control the display unit 35. The control unit 37 may include a controller configured to control the indoor unit. The vent hole 351 is formed in the rear frame 34 to circulate air into the display panel 30.

The control unit 37 may be disposed on one surface of the display unit 35. The control unit 37 may be coupled to a rear surface of the display unit 35. When viewed from the rear, the area of the control unit 37 may be less than the area of the display unit 35.

The display unit 35 may be positioned to overlap the inlet 15 in a rotation axis direction of the blower fan 14. The inlet 15 may be positioned behind the display unit 35.

The control unit 37 may be positioned to overlap the inlet 15 in the rotation axis direction of the blower fan 14. The inlet 15 may be positioned behind the control unit 37.

As the display unit 35 and the control unit 37 are positioned forward relative to the inlet 15, air introduced through the air gap 70 and the panel inlet 39 is discharged to the outlet 16 through inlet 15 when the blower fan 14 is operated in response to overheating of the control unit 37. As air in the air gap 70 is introduced through the inlet 15, the flow velocity and flow rate of air introduced into the display panel 30 are increased, allowing the heat exchange efficiency to be improved.

The inlet 15 is positioned at a surface of the cabinet 10 that faces the display panel 30. The inlet 15 may be positioned at a front surface of the cabinet 10. In other words, as described above, the inlet 15 is formed in the front panel 20 that defines the front surface of the cabinet 10.

The air gap 70 may be defined as a gap (empty space or clearance) between the display panel 30 and the cabinet 10 or between the front frame 32 and the rear frame 34 of the display panel 30. The air gap 70 provides a space that allows outside air to be introduced, be heat-exchanged with the display unit 35, and be discharged to the outside.

The air gap 70 has a structure in which air heated by the display unit 35 and/or the control unit 37 is moved by convection.

The display panel 30 and the cabinet 10 may be completely spaced apart from each other, but the display panel 30 may be in contact with a portion of the cabinet 10. Accordingly, the air gap 70 between the display panel 30 and the cabinet 10 may define a flow path open at least at the top and the bottom.

Preferably, the air gap 70 between the display panel 30 and the cabinet 10 may define a flow path open at least at the top, the bottom, the left, and the right.

The air gap 70 between the front frame 32 and the rear frame 34 of the display panel 30 may define a flow path in the display unit 35, which is open at least at the bottom, the left, and the right.

For example, the air gap 70 may include a first air gap 71 positioned below the display unit 35, a second air gap 72 positioned above the display unit 35, and a third air gap 73 in communication with the first air gap 71 and the second air gap 72.

The first air gap 71 may be positioned below the control unit 37, the second air gap 72 may be positioned above the control unit 37, and at least a portion of the third air gap 73 may be positioned at a same height as the control unit 37.

The first air gap 71 is a space between a lower end of the display panel 30 and a lower end of the cabinet 10, and/or a space between the front frame 32 and the rear frame 34, the second air gap 72 is a space between an upper end of the display panel 30 and an upper end of the cabinet 10, and the third air gap 73 is a space between a middle (or central) portion of the display panel 30 and a middle (or central) portion of the cabinet 10.

Outside air may be introduced through the first air gap 71, may be heat-exchanged with the display unit 35 and/or the control unit 37 in the third air gap 73, and may be discharged to the outside through the second air gap 72.

The third air gap 73 may be positioned to horizontally overlap the display unit 35. The third air gap 73 may be positioned behind the display unit 35.

The inlet 15 may be in communication with the air gap 70. As the air gap 70 and the inlet 15 communicate with each other, outside air is naturally drawn into the inlet 15 through the air gap 70 during the cooling operation of the indoor unit, the flow velocity and flow rate of air flowing through the air gap 70 are increased to thereby improve the cooling capacity. Even when the blower fan 14 rotates at a low speed, the flow velocity and flow rate of the air flowing through the air gap 70 can be increased.

That is, as the inlet 15 is in communication with the air gap 70, the display unit 35 and the control unit 37 may be cooled simultaneously with the cooling operation.

Specifically, the inlet 15 may be positioned to overlap at least the third air gap 73 in the front-and-rear direction. The inlet 15 may be positioned behind the third air gap 73.

As the third air gap 73 is positioned forward relative to the inlet 15, when the blower fan 14 is operated in response to overheating of the control unit 37, or in the cooling mode of operation, air introduced through the air gap 70 is discharged to the outlet 16 through the inlet 15.

Accordingly, air heat-exchanged with the display unit 35 in the air gap 70 is introduced through the inlet 15, allowing the heat exchange efficiency to be increased.

A rear surface of the display panel 30 is exposed at the air gap 70. One surface of the display unit 35 may be exposed at the air gap 70. Specifically, the rear surface of the display unit 35 may be exposed at the air gap 70. The rear surface of the display unit 35 may be the largest surface among surfaces of the display unit 35.

One surface of the control unit 37 may be exposed at the air gap 70. Specifically, a rear surface of the control unit 37 may be exposed at the air gap 70. The rear surface of the control unit 37 may be the largest surface among surfaces of the control unit 37. As the largest surfaces of the display unit 35 and the control unit 37 are exposed at the air gap 70, the heat exchange efficiency can be maximized.

The display panel 30 includes an engaging portion 38. The engaging portion 38 may allow the display panel 30 to be placed onto an engaged portion 210 of the cabinet 10.

For example, the engaging portion 38 may protrude rearward from the rear surface of the display panel 30. Specifically, the engaging portion 38 may protrude rearward of the display panel 30 from a front surface of the display panel 30 and then protrude downward.

The engaging portion 38 allows the display panel 30 to be secured to the cabinet 10 in a closed state of the display panel 30, serves as the center of rotation of the display panel 30 during the process of opening the display panel 30, and supports the display panel 30 in an open state of the display panel 30.

More heat is generated in the control unit 37 than in the display unit 35, and accordingly, heat is concentrated in the control unit 37. Therefore, the indoor unit of the air conditioner according to an embodiment of the present disclosure may further include an air guide 300 configured to guide or concentrate air flowing through the panel inlet 39 and the air gap 70 into the control unit 37.

For example, the air guide 300 may include a first air guide 310 and a second air guide 320 disposed to face the first air guide 310.

The control unit 37 may be positioned between the first air guide 310 and the second air guide 320. The first air guide 310 and the second air guide 320 may protrude from one surface of the display unit 35 or one surface of the rear frame 34. Specifically, the first air guide 310 and the second air guide 320 may protrude rearward from the rear surface of the display unit 35, may protrude forward from the rear surface of the display unit 35, or may protrude forward from a front surface of the rear frame 34.

An acceleration passage 74 may be defined between the first air guide 310 and the second air guide 320. The air guide 300 may have a shape such that top and bottom sides of the control unit 37 are open and left and right sides of the control unit 37 are closed.

The first air guide 310 may be positioned at the left side of the control unit 37 and may have a longer vertical length than the control unit 37. The second air guide 320 may be positioned at the right side of the control unit 37 and may have a longer vertical length than the control unit 37.

Portions of the first air guide 310 and the second air guide 320 are positioned to overlap the control unit 37 in the left-and-right direction, and the first air guide 310 and the second air guide 320 are disposed so as not to overlap the control unit 37 in the up-and-down direction.

Air flowing through the air gap 70 is introduced into a space between the first air guide 310 and the second air guide 320, so as to be guided to the control unit 37.

The air guide 300 may be divided into a lower section S1, a central section S2, and an upper section S3. The lower section S1 is a section located at a lower height than the control unit 37, the central section S2 is a section having at least a portion located at a same height as the control unit 37, and the upper section S3 is a section located at a higher height than the control unit 37.

A distance between the first air guide 310 and the second air guide 320 in the lower section S1 may be greater than a distance between the first air guide 310 and the second air guide 320 in the central section S2.

The first air guide 310 located in the lower section S1 may be referred to as a first lower portion 311; the second air guide 320 located in the lower section S1 may be referred to as a second lower portion 321; the first air guide 310 located in the central section S2 may be referred to as a first central portion 315; the second air guide 320 located in the central section S2 may be referred to as a second central portion 325; the first air guide 310 located in the upper section S3 may be referred to as a first upper portion 313; and the second air guide 320 located in the upper section S3 may be referred to as a second upper portion 323.

Specifically, a distance between the first lower portion 311 and the second lower portion 321 may be greater than a distance between the first central portion 315 and the second central portion 325.

The distance between the first air guide 310 and the second air guide 320 in the lower section S1 may decrease toward the central section S2. The distance between the first lower portion 311 and the second lower portion 321 may decrease from bottom to top. The first lower portion 311 may be inclined upward from left to right, and the second lower portion 321 may be inclined upward from right to left.

Due to the arrangement of the first lower portion 311 and the second portion 321, air introduced to an outside of the air guide 300 is accelerated to thereby increase the flow rate.

The distance between the first central portion 315 and the second central portion 325 may be constant in the up-and-down direction. A distance between the first air guide 310 and the second air guide 320 in the upper section S3 may be greater than the distance between the first air guide 310 and the second air guide 320 in the central section S2.

Specifically, a distance between the first upper portion 313 and the second upper portion 323 may be greater than the distance between the first central portion 315 and the second central portion 325.

The distance between the first air guide 310 and the second air guide 320 in the upper section S3 may decrease toward the central section S2. The distance between the first upper portion 313 and the second upper portion 323 may increase from bottom to top. The first upper portion 313 may be inclined upward from right to left, and the second upper portion 323 may be inclined upward from left to right.

Due to the arrangement of the first upper portion 313 and the second upper portion 323, the flow velocity of air heat-exchanged with the control unit 35 is slow, which results in an increase in contact time with the display unit 35 and an increase in contact area with the display unit 35.

The vent hole 351 may be positioned between an upper end (or top) of the first upper portion 313 and an upper end (or top) of the second upper portion 323. A space between the upper end of the first upper portion 313 and the upper end of the second upper portion 323 may vertically overlap a plurality of vent holes 351. The vent hole 351 may be positioned above the space between the upper end of the first upper portion 313 and the upper end of the second upper portion 323.

Air discharged from the upper section S3 of the air guide 300 is slowed down and spread out to thereby provide time for the air to be introduced into the display unit 35 through the vent hole 351, allowing the heat exchange efficiency to be increased.

The air guide 300 may serve as a reinforcing member for reinforcing the rigidity of the display unit 35. The air guide 300 prevents warping (or twisting) and vibration of the display unit 35 and reinforces the rigidity of the display unit 35.

Further, in the present disclosure, the panel inlet 30 may be formed in the display panel 30. The panel inlet 39 is a space through which outside air is introduced into the display panel 30. The outside air introduced through the panel inlet 39 may be heat-exchanged with the display unit 35 and the control unit 37 in the display panel 30, and then may be discharged to the top of the display panel 30.

For this purpose, a hole through which air is drawn in and out may be formed in each of the upper and lower ends of the display panel 30.

In addition, some of the outside air drawn in through the panel inlet 39 may be introduced into the display unit 35 to exchange heat with the display unit 35, then may be discharged through the vent hole 351, and then may flow into the second air gap 72 to be discharged to the top of the display panel 30.

The panel inlet 39 may be a hole formed through a lower surface of the display panel 30. The panel inlet 39 may be in communication with the outside and the air gap 70. Specifically, the panel inlet 39 may be in communication with the first air gap 71.

At least a portion of the panel inlet 39 may vertically overlap the display unit 35 and the control unit 37. As at least the portion of the panel inlet 39 vertically overlaps the display unit 35 and the control unit 37, when air heated in the display unit 35 and the control unit 37 flows upward, outside air may be quickly supplied to the display unit 35 and the control unit 37 from the panel inlet 39 at the bottom to thereby increase the heat exchange efficiency.

In addition, the panel inlet 39 may be positioned below the display unit 35 and the control unit 37.

The display panel 30 and the cabinet 10 may be moved relative to each other by a link. The link may include a connecting link 3a and an auxiliary link 3c.

The connecting link 3a may be hingedly connected to each of the display panel 30 and the cabinet 10. The connecting link 3a may include a first link 331 having one end (or first end) hinged to the cabinet 10, and a second link 332 having one end (or first end) hinged to the first link 331 and the other end (or second end) hinged to the display panel 30. A length of the second link 332 may be greater than a length of the first link 331. A link motor 3b may be connected to the connecting link 3a.

The first link 331 is connected to the cabinet 10 by a first hinge 334, the first link 331 is connected to the second link 332 by a second hinge 333, and the second link 332 is connected to the display panel 30 by a third hinge 335.

In a state where the display panel 30 is open, the first link 331 and the second link 332 spread apart while forming an obtuse angle with each other. An angle between the first link 331 and the second link 332 is preferably 150 to 180 degrees while the display panel 30 is open.

In a state where the display panel 30 is closed, the first link 331 and the second link 332 are folded while forming an acute angle with each other. An angle between the first link 331 and the second link 332 is preferably 1 to 30 degrees while the display panel 30 is closed. Portions of the first link 331 and the second link 332 may be accommodated in the cabinet 10 while the display panel 30 is closed.

The auxiliary link 3c is hingedly connected to each of the display panel 30 and the cabinet 10. A pair of auxiliary links 3c may be provided. The connecting link 3a may be disposed between the pair of auxiliary links 3c.

The connecting link 3a may be positioned above the auxiliary link 3c, and a total length of the connecting link 3a may be greater than a total length of the auxiliary link 3c.

Meanwhile, various images indicating information may be displayed on the display unit 35. For example, the display unit 35 may include at least one of a time information image containing time information, a temperature information image showing indoor temperature and/or outdoor temperature information, a weather information image containing information of current weather for current location, an operation information image containing operation information of the indoor unit, and an image designated by a user.

In addition, the display unit 35 may be implemented as a touch screen to receive a user command. Alternatively, a user command may be received by a separate remote controller. Alternatively, a user command may be received by an application installed on a terminal (not shown) connected to the indoor unit via wired or wireless communication.

Specifically, the indoor unit may be connected to an external server through a communication unit. In addition, an additional access point may be provided to relay the connection between the external server and the indoor unit. In one example, the access point may be a Wi-Fi router.

Through a user command, a user may change a background image displayed on the display unit 35, or may select to display or not to display at least one of the time information image, the temperature information image, the weather information image, and the operation information image.

In detail, when the user selects an image through an application installed on a terminal (of the user), the terminal may determine whether the selected image is an existing image included in the indoor unit or a new image.

When the selected image is an existing image, the terminal transmits a user command for changing the image to the external server. The external server may identify the received user command to specify the indoor unit to which the image is applied, and then may transmit the user command for changing the image to the indoor unit.

When the selected image is a new image, the terminal transmits a user command for changing the image and new image data to the external server. The external server may determine whether the received new image data is applicable to the indoor unit, and may perform image conversion based on the image being inappropriate. The external server may identify the received user command to specify the indoor unit to which the image is applied, and then may transmit the user command for changing the image and the new image data to the indoor unit. Image conversion may be performed on the terminal or the indoor unit rather than on the external server.

In addition, when the image selected on the terminal by the user is an image prestored in a server, a background image may be transmitted to the indoor unit from the external server.

Further, the user may download, through the terminal, a background image from an external server (not shown) and transmits it to the display unit 35.

Hereinafter, the flow of air through the air gap 70 will be described.

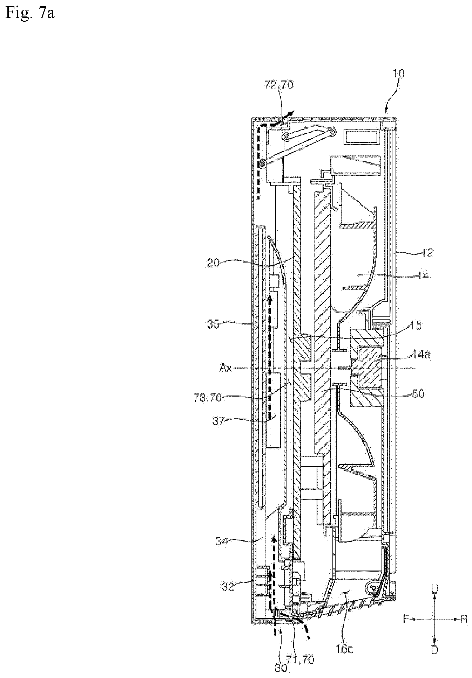

FIG. 7A illustrates an air flow by natural convection while the display panel is closed.

Referring to FIG. 7A, the indoor unit may be in a state in which the display unit 35 is on and a compressor (not shown) is stopped. When the temperature of the control unit 37 is lower than or equal to a first set temperature, the blower fan 14 does not operate. In this case, the control unit 37 and the display unit 35 are cooled by air passing through the air gap 70.

Specifically, air heated by heat of the display unit 35 and the control unit 37 decreases in density which moves the air upward, generating a convection current. Due to this convection of air, outside air is introduced through the first air gap 71 and the panel inlet 39, is heat-exchanged with the display unit 35 and the control unit 37, and is discharged through the vent hole 351. The air discharged through the vent hole 351 is released to the outside through the second air gap 72.

In addition, due to this convection of air, outside air is introduced through the panel inlet 39. Part of the outside air introduced through the panel inlet 39 may flow into the third air gap 73, may be heat-exchanged with the display unit 35 and the control unit 37, and then may be discharged through the second air gap 72. Another part of the outside air may be introduced into the display unit 35, may be heat-exchanged with the display unit 35, then may be discharged to the third air gap 73 through the vent hole 351, and then may be discharged to the outside through the second air gap 72.

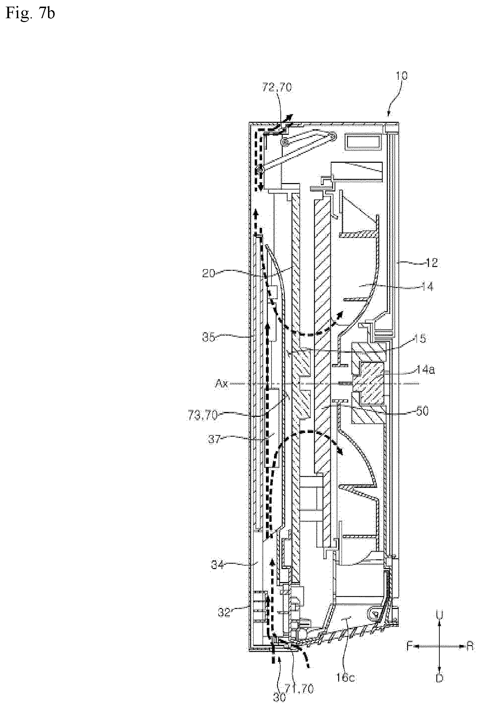

FIG. 7B illustrates an air flow when a blower fan is operated while the display panel is closed.

Referring to FIG. 7B, when the temperature of the control unit 37 is greater than or equal to a second set temperature as the display unit 35 is on, the blower fan 14 is operated. By the operation of the blower fan 14, outside air is introduced through the panel inlet 39 and the air gap 70. Part of the outside air is introduced into the first air gap 71 by heat of the display unit 35 and the control unit 37, and is discharged to the outside through the second air gap 72.

Another part of the outside air is introduced through the panel inlet 39. Part of the outside air introduced through the panel inlet 39 may flow into the third air gap 73 to exchange heat with the display unit 35 and the control unit 37, and then may be discharged through the second air gap 72 or discharged to the outside through the outlet 16 by passing through the inlet 15.

Another part of the outside air introduced through the panel inlet 39 may flow into the display unit 35 to exchange heat with the display unit 35, then may be discharged to the third air gap 73 through the vent hole 351, and then may be discharged through the second air gap 72 or discharged to the outside through the outlet 16 by passing through the inlet 15.

Another part of the outside air may be introduced into the third air gap 73 through the first air gap 71 and the second air gap 72, and then may pass through the inlet 15 to be discharged to the outside through the outlet 16.

Thus, the control unit 37 and the display unit 35 may be cooled by the air flow by the rotation of the blower fan 14.

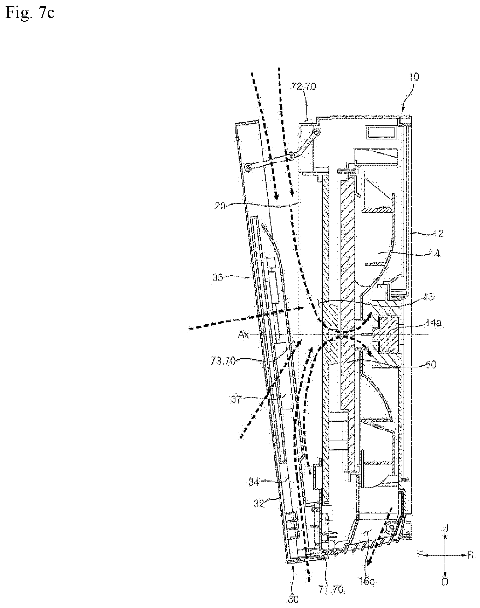

FIG. 7C illustrates an air flow when a blower fan is operated while the display panel is open.

When the temperature of the control unit 37 is greater than or equal to a fourth set temperature as the display unit 35 is on, the blower fan 14 may be operated while the display panel 34 is open. When the indoor unit is operated as an evaporator to cool the indoor temperature, the display panel 30 is open, so that a gap between the display panel 30 and the cabinet 10 is widened, allowing the inlet 15 to be exposed to the outside. The display panel 30 rotates about a lower end of the cabinet 10, causing an upper end of the display panel 30 and an upper end of the cabinet 10 to spread apart.

Part of the outside air is introduced into the second air gap 72 and/or a space between the upper end of the display panel 30 and the upper end of the cabinet 10, is heat-exchanged with the heat exchanger 50, and then passes through the inlet 15 to be discharged through the outlet 16. The control unit 37 and the display unit 35 may be cooled by the outside air introduced into the second air gap 72 and/or the space between the upper end of the display panel 30 and the upper end of the cabinet 10.

Another part of the outside air is introduced into the third air gap 73 and/or a space between a middle end of the display panel 30 and a middle end of the cabinet 10, flows to the center of the air gap 70, then is heat-exchanged with the heat exchanger 50, and then passes through the inlet 15 to be discharged through the outlet 16. The control unit 37 and the display unit 35 are cooled by the outside air introduced into the third air gap 73 and/or the space between the middle end of the display panel 30 and the middle end of the cabinet 10.

Another part of the outside air is introduced through the panel inlet 39. Part of the outside air introduced into the panel inlet 39 by the operation of the blower fan 14 may be heat-exchanged with the display unit 35 and the control unit 37, and then may be discharged through the vent hole 351 of the rear frame 34 or discharged to the outside through the outlet 16 by passing through the inlet 15.

Another part of the outside air introduced through the panel inlet 39 may flow into the display unit 35, may be heat-exchanged with the display unit 35, then may be discharged through the vent hole 351, and then may be discharged to the outside through the second air gap 72 or discharged to the outside through the outlet 16 by passing through the inlet 15.

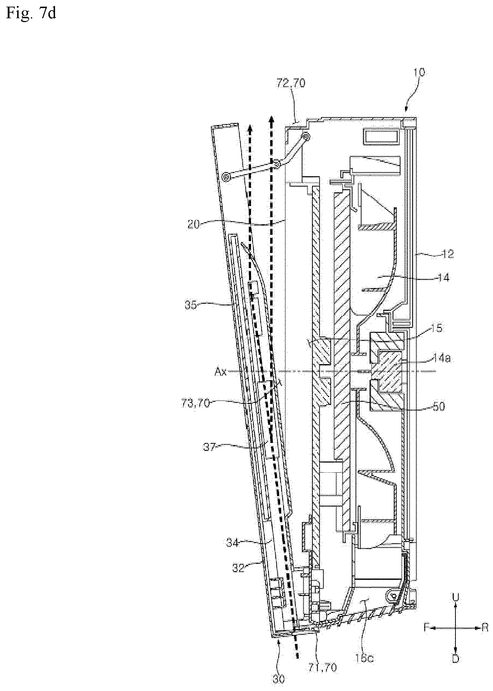

FIG. 7D illustrates an air flow when a blower fan is not operated while the display panel is open.

Although the display unit 35 is on, when the temperature of the control unit 37 is higher than a third set temperature and lower than the fourth set temperature, the display panel 30 may be changed to an open state.

As the display panel 30 is open, air heated by heat of the display unit 35 and the control unit 37 decreases in density which moves the air upward, generating a convection current. Due to this convection of air, outside air is introduced through the first air gap 71, and the outside air introduced through the first air gap 71 is heat-exchanged with the display unit 35 and the control unit 37 in the third air gap 73, and then is discharged to the outside through the second air gap 72.

In addition, due to this convection of air, outside air may be introduced through the panel inlet 39. Part of the outside air introduced through the panel inlet 39 may be heat-exchanged with the display unit 35 and the control unit 37, and then may be discharged to the second air gap 72 through the vent hole 251 of the rear frame 34. Another part of the outside air introduced through the panel inlet 39 may be introduced into the display unit 35, may be heat-exchanged with the display unit 35, then may be discharged to the third air gap 73 through the vent hole 351, and then may be discharged to the outside through the second air gap 72.

Further, due to this convection of air, outside air is introduced from an outside of the third air gap 73 through the third air gap 73. The outside air introduced through the third air gap 73 is heat-exchanged with the display unit 35 and the control unit 37 in the third air gap 73, and then is discharge to the outside through the second air gap 72.

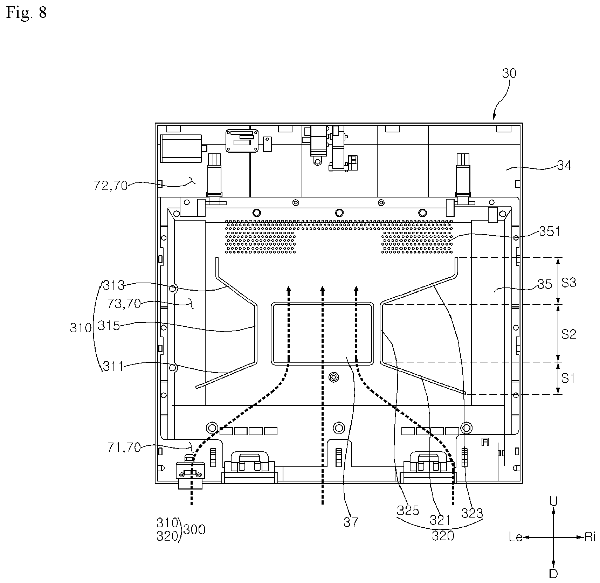

FIG. 8 illustrates an air flow in the vicinity of a control unit.

Referring to FIG. 8, outside air introduced through the air gap 70 and the panel inlet 39 cools the display unit 35 and is accelerated and concentrated through the air guide 300 to cool the control unit 37. The air used to cool the control unit 37 becomes slow in diffusion and flow velocity, cools the display unit 35, and is supplied to the vent hole 351.

FIG. 9A illustrates a display panel according to another embodiment of the present disclosure, when viewed from the rear.

Compared to the embodiment of FIG. 6, an upper portion of the air guide 300 is not provided in this embodiment of FIG. 9. In the following description, the differences from the embodiment of FIG. 6 will be mainly discussed, and a description of the same configuration as the embodiment of FIG. 6 will be omitted.

Referring to FIG. 9, the first air guide 310 may include a first lower portion 311 and a first central portion 315, and the second air guide 320 may include a second lower portion 321 and a second central portion 325.

Without a separate guide, air that has passed through a central section S2 of the air guide 300 may be spread and introduced into the vent hole 351, and may sufficiently exchange heat with the upper end of the display unit 35.

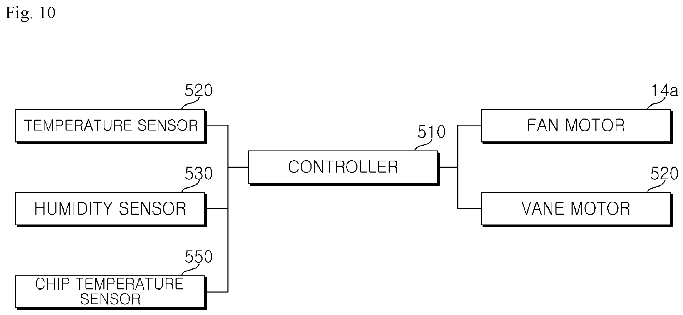

FIG. 10 is a control block diagram according to an embodiment of the present disclosure.

Referring to FIG. 10, the present disclosure may further include a temperature sensor 525, a humidity sensor 530, a chip temperature sensor 540, and a controller 560.

The temperature sensor 525 may be installed at the cabinet 10. Specifically, the temperature sensor 525 may be installed to be adjacent to the left inlet 16a or the right inlet 16b. The temperature sensor 525 may provide temperature information to the controller 560.

The chip temperature sensor 540 may be installed at the display unit 35. Specifically, the chip temperature sensor 540 may be installed at the rear surface of the display unit 35 to be adjacent to the control unit 37. The chip temperature sensor 540 may measure the temperature of the control unit 37 and provide temperature information of the control unit 37 to the controller 560.

The humidity sensor 530 may be installed at the cabinet 10. Specifically, the humidity sensor 530 may be installed to be adjacent to the left outlet 16a or the right outlet 16b. The humidity sensor 530 may provide relative humidity information to the controller 560.

The controller 560 may determine a dew formation condition based on temperature and humidity around the cabinet 10 and a rotational speed of the fan motor 14a. When the dew formation condition is satisfied, the controller 560 may control the vane motor 520 such that the control vane 510 closes the second outlet 16c.

When the second outlet 16c is closed by the control vane 510 under the dew formation condition, the flow velocity of air discharged to the first outlet 16a, 16b increases, thereby preventing the formation of dew on the first outlet 16a, 16b and the second outlet 16c.

When the temperature around the cabinet 10 is in a predetermined temperature range, the humidity around the cabinet 10 is greater than or equal to predetermined reference humidity, and the rotational speed of the fan motor 14a is less than a reference speed, the controller 560 may determine that the dew formation condition is satisfied.

In addition, when the dew formation condition is satisfied, the controller 560 may increase the rotational speed of the fan motor 14a from a current rotational speed. When the rotational speed of the fan motor 14a is increased from the current rotational speed based on the dew formation condition being satisfied, the formation of dew on the outlet 16 can be prevented.

Further, when the temperature of the control unit 37 is higher than a critical temperature, the controller 560 may control the fan motor 14a to rotate the blower fan 14. When the temperature of the control unit 37 is higher than the critical temperature, the controller 560 may control the fan motor 14a to rotate the fan motor 14a at a rotational speed lower than a speed in the normal operation.

The indoor unit of the present disclosure has one or more of the following effects.

First, as a display panel is coupled to a front surface of a cabinet, an air gap through which air flows is positioned between the display panel and the cabinet, and one surface of a display is exposed at the air gap, air heated by heat generated in the display can flow by natural convection. As outside air is introduced from the bottom of the air gap to be discharged to the top, the display can be effectively cooled without a blower fan or a separate driving device. In addition, a separate flow path or passage is not formed in the cabinet, thereby reducing the manufacturing cost.

Second, as the display panel is coupled to the front surface of the cabinet, the air gap through which air flows is positioned between the display panel and the cabinet, a control unit is disposed at one surface of the display, and a passage structure that allows air flowing through the air gap is provided in one surface of the display, the control unit where a large amount of heat is generated can be effectively cooled.

Third, as an air guide that concentrates air flowing through the air gap has a structure that decreases in width from bottom to top, has a minimum width in the vicinity of the control unit, and decreases in width upward from the vicinity of the control unit, the air can be concentrated into the control unit and the flow velocity of the air can be increased, thereby improving the heat exchange efficiency.

Fourth, as the blower fan is rotated when heat generated in the display and the control unit exceed the amount of cooling by natural convection, the speed and amount of outside air introduced into the air gap can be increased. As part of air heat-exchanged in the display and the control unit is discharged to the top of the air gap by natural convection, and another part of the air heat-exchanged in the display and the control unit is introduced into the cabinet through an inlet and is then discharged through an outlet, an additional cooling capacity can be provided by the blower fan when exceeding the amount of cooling by natural convection.

Fifth, as a rear side of the outlet has a shallower inclination angle than a discharge guide, a smooth change in direction can be achieved when air discharged from the outlet through the discharge guide, the air discharged through the outlet can be increased in flow velocity and have a uniform speed, thereby preventing the formation of dew around the outlet.

Sixth, as the discharge guide located on the same plane as the rear side of the outlet is configured to have a portion with the same inclination angle as the rear side of the outlet and a portion with a greater inclination angle than the rear side of the outlet, allowing air discharged from the outlet to the discharge guide to be more smoothly changed in direction of the air to thereby prevent the formation of dew on the rear side of the outlet. In addition, as the discharge guide has a large angle at the rear side of the outlet, the formation of dew on a wall adjacent to the rear side of the outlet can be prevented.

The above-described features, configurations, effects, and the like are included in at least one of the embodiments of the present disclosure, and should not be limited to only one embodiment. In addition, the features, configurations, effects, and the like as illustrated in each embodiment may be implemented with regard to other embodiments as they are combined with one another or modified by those skilled in the art. Thus, content related to these combinations and modifications should be construed as including in the scope of the disclosure as disclosed in the accompanying claims.

## Claims

1. An indoor unit of an air conditioner comprising:
a cabinet (10) having an inlet (15) through which air is introduced and an outlet (16) through which air is discharged;
a heat exchanger (50) disposed in the cabinet (10);
a blower fan (14) disposed in the cabinet (10);
a display panel (30) comprising a display unit (35), the display panel (30) being coupled to the cabinet (10); and
an air gap (70) between the display panel (30) and the cabinet (10) for allowing air to flow along the display panel (30) for heat-exchange.

2. The indoor unit of claim 1, wherein in a mounted state of the indoor unit, the display panel (30) is disposed in vertical orientation.

3. The indoor unit of claim 1 or 2, wherein the air gap (70) comprises:
a first air gap (71) positioned below the display unit (35);
a second air gap (72) positioned above the display unit (35); and
a third air gap (73) connecting the first air gap (71) and the second air gap (72) to each other and extending along the display panel (30).

4. The indoor unit of claim 3, wherein by natural convection, air is introduced into the first air gap (71), performs heat-exchange with the display panel (30) while flowing along the third air gap (73), and is discharged to the outside through the second air gap (72).

5. The indoor unit according to any one of the preceding claims,
wherein the inlet (15) is positioned at a surface of the cabinet (10) that faces the display panel (30).

6. The indoor unit according to any one of the preceding claims, wherein the inlet (15) is in communication with the air gap (70); and/or
wherein the inlet (15) overlaps the display unit (30) on a virtual extension line of a rotation axis of the blower fan (14).

7. The indoor unit according to any one of the preceding claims, wherein the display unit (35) and/or the display panel (30) has one surface exposed to the air gap (70).

8. The indoor unit according to any one of the preceding claims, wherein the display panel (30) further comprises a control unit (37) configured to control the display unit (35), and
wherein the control unit (37) is disposed on one surface of the display unit (35) and/or is exposed to the air gap (70).

9. The indoor unit of claim 8, further comprising an air guide (310, 320) configured to guide air flowing through the air gap (70) to the control unit (37), and
wherein the air guide comprises:
a first air guide (310); and
a second air guide (320) disposed to face the first air guide (310), and
wherein the control unit (37) is positioned between the first air guide (310) and the second air guide (320).

10. The indoor unit of claim 9, wherein the air guide (310, 320) comprises:
a lower section (S1) positioned at a lower height than the control unit (37); and
a central section (S2) having at least a portion positioned at a same height as the control unit (37), and
wherein a distance between the first air guide (310) and the second air guide (320) in the lower section (S 1) is greater than a distance between the first air guide (310) and the second air guide (320) in the central section (S2).

11. The indoor unit of claim 10, wherein the distance between the first air guide (310) and the second air guide (320) in the lower section (S1) decreases toward the central section (S2).

12. The indoor unit of claim 10 or 11, wherein the air guide (310, 320) further comprises an upper section (S3) positioned at a higher height than the control unit (37), and
wherein a distance between the first air guide (310) and the second air guide (320) in the upper section (S3) is greater than the distance between the first air guide (310) and the second air guide (320) in the central section (S2).

13. The indoor unit of claim 12, wherein the distance between the first air guide (310) and the second air guide (320) in the upper section (S3) decreases toward the central section (S2).

14. The indoor unit according to any one of the preceding claims in combination with claim 8, further comprising:
a chip control sensor (550) to measure a temperature of the control unit (37); and
a controller (510) to control the blower fan (14),
wherein the controller (510) is configured to control the blower fan (14) to rotate based on the temperature of the control unit (37) being higher than a critical temperature.

15. The indoor unit of claim 14, wherein the controller (510) is configured to, based on the temperature of the control unit (37) being higher than the critical temperature, rotate the blower fan (14) at a speed lower than a speed in a normal operation for air conditioning.
